# EUROPÄISCHE PATENTSCHRIFT

(11) **EP 3 032 747 B1**
(45) Veröffentlichungstag und Bekanntmachung des Hinweises auf die Patenterteilung: **20.02.2019**
(21) Anmeldenummer: 15198568.6
(22) Anmeldetag: 09.12.2015
(51) Int. Cl.: H03K 17/96

(54) **KRAFTFAHRZEUG MIT BRUCHGESCHÜTZTEM TOUCHPAD**
MOTOR VEHICLE WITH RUPTURE PROTECTED TOUCHPAD
VEHICULE AUTOMOBILE COMPRENANT UNE TABLETTE TACTILE ANTI-RUPTURE

(30) Priorität: 11.12.2014 DE 102014018355
(43) Veröffentlichungstag der Anmeldung: 15.06.2016
(73) Patentinhaber: AUDI AG, 85045 Ingolstadt (DE)
(72) Erfinder: Wachinger, Michael, 86571 Winkelhausen (DE)

(56) Entgegenhaltungen:
- WO-A2-2013/104400
- DE-U1-202012 103 286
- US-A1- 2011 141 052

## Beschreibung

Die Erfindung betrifft eine Bedienvorrichtung für ein Kraftfahrzeug. Die Bedienvorrichtung weist ein Touchpad auf, über welches zusätzlich zu einem Berührort auch eine Anpresskraft ermittelt werden kann, welche ein Benutzer auf einer Bedienfläche einer Berührscheibe des Touchpads ausübt. Hierzu ist unter dem Touchpad eine Sensoreinrichtung zum Erfassen einer Druckkraft angeordnet.

Eine solche Anordnung aus Touchpad und Sensor für eine Druckkraft ist beispielsweise aus der EP 2 546 730 A2 bekannt. Danach ist eine Berührscheibe aus Glas gefertigt, an dessen Unterseite eine biegsame Sensormatrix zum Erfassen des Berührortes an der Glasfläche bereitgestellt ist. Unterhalb dieser Sensormatrix ist des Weiteren ein Sensor bereitgestellt, welcher einen Abstand der Glasplatte von einer Bodenelektrode erfasst. Bei Drücken der Glasplatte wird diese durchgebogen, sodass sich ihr Abstand zu der Bodenelektrode verändert.

Bei dieser bekannten Anordnung ergibt sich der Nachteil, dass die Glasplatte fest eingespannt sein muss, damit ein Benutzer genügend Druckkraft ausüben kann, um die Scheibe durchzubiegen. Eine derart fest eingespannte Glasscheibe kann aber bruchanfällig sein. Grund dafür ist, dass beim Aufschlagen eines Gegenstandes auf die Glasscheibe, beispielsweise eines Fahrzeugschlüssels, der dem Benutzer beim Einsteigen aus der Hand rutscht, die Glasscheibe starr bleibt, das heißt dem aufschlagenden Gegenstand nicht nachgibt, und hierdurch der Impuls des auftreffenden Gegenstands in verhältnismäßig kurzer Zeit auf das Glas übertragen wird. Dies kann zum Bruch des Glases führen.

In der WO 2013/104400 A2 ist eine Eingabevorrichtung beschrieben, bei welcher ein Touchpad auf einem verschwenkbar gelagerten Trägerteil beweglich gelagert ist, wobei die Beweglichkeit mittels eines Schlittens erreicht wird, auf welchem das Touchpad entlang des Trägerteils gleiten kann. Das Trägerteil ist an einer Drehachse drehbar gelagert und liegt auf einem Kraftsensor auf, auf welchen eine auf das Touchpad wirkende Druckkraft übertragen werden kann.

In der DE 20 2012 103 286 U1 ist ein Touchpad beschrieben, das starr in einem Gehäuse eines Smartphones angeordnet ist. Eine Berührungssensorik des Touchpads ist durch eine Matrix aus elektrisch leitenden Elementen gebildet, die auf einer Leiterplatte angeordnet sind.

Der Erfindung liegt die Aufgabe zugrunde, bei einem Touchpad mit Druckkrafterfassung einen Schutz der Berührscheibe gegen Bruch bei Beaufschlagung mit einer Kraft bereitzustellen.

Die Aufgabe wird durch die Gegenstände der unabhängigen Patentansprüche gelöst. Vorteilhafte Weiterbildungen der Erfindung ergeben sich durch die Merkmale der abhängigen Patentansprüche.

Durch die Erfindung wird bereitgestellt eine Bedienvorrichtung für ein Kraftfahrzeug. Diese weist in der beschriebenen Weise ein Touchpad zum Erzeugen eines Berührsignals auf. Das Berührsignal wird in Abhängigkeit von einem Berührort auf einer Bedienfläche einer Berührscheibe des Touchpads erzeugt. Dies entspricht der an sich bekannten Funktionalität eines Touchpads. Ein Touchpad weist also eine Berührscheibe auf, durch welche eine Bedienfläche bereitgestellt ist, also eine durch den Benutzer erreichbare Bedienoberfläche. Der Berührort kann durch eine Sensormatrix ermittelt werden, die das Berührsignal erzeugt. Zu der erfindungsgemäßen Bedienvorrichtung gehört auch eine Sensoreinrichtung mit zumindest einem Sensor zum Erzeugen eines Drucksignals. Dieses Drucksignal wird in Abhängigkeit von einer auf den Sensor wirkenden Druckkraft erzeugt, d.h. der Sensor ist ein Drucksensor oder Kraftsensor. Anders als bei dem Touchpad selbst ist bei der Sensoreinrichtung eine sehr viel kleinere Zahl an Sensoren nötig, beispielsweise ein einzelner Sensor oder zwei Sensoren oder drei Sensoren oder vier Sensoren. Um eine Anpresskraft, die der Benutzer auf die Bedienfläche ausübt, beispielsweise mit dem Finger oder einem anderen Bedienobjekt, als Druckkraft auf die Sensoreinrichtung zu übertragen, ist eine Trägereinrichtung bereitgestellt, durch welche das Touchpad bezüglich der Sensoreinrichtung derart bewegbar gelagert ist, dass die Anpresskraft als Druckkraft auf die Sensoreinrichtung übertragen wird.

Um nun das Touchpad gegen Bruch bei Beaufschlagung mit einer Kraft zu schützen, ist erfindungsgemäß vorgesehen, dass das Touchpad an dieser Trägereinrichtung nicht starr, sondern mittels zumindest eines Schwenkelements befestigt ist. Mit anderen Worten ist das Touchpad nicht starr oder unbeweglich an der Trägereinrichtung angeordnet, sondern kann an der Trägereinrichtung z.B. hin- und her schwingen oder wippen oder vibrieren. Als Schwenkelement kann z.B. jeweils eine Blattfeder bereitgestellt werden. Der bereitgestellte Bewegungsweg des Touchpads ist bevorzug in zumindest eine Richtung oder in zumindest zwei Richtungen jeweils größer als 1 Millimeter, insbesondere größer als 5 Millimeter.

Durch das zumindest eine Schwenkelement ist das Touchpad dabei parallel zu der Bedienfläche bezüglich der Trägereinrichtung auslenkbar. Mit anderen Worten kann die Berührscheibe des Touchpads in der Ebene der Bedienfläche bewegt werden. Dagegen ist das Touchpad senkrecht zur Ebene der Bedienfläche durch das zumindest eine Schwenkelement starr an der Trägereinrichtung gelagert. Mit anderen Worten wird eine senkrecht auf die Bedienfläche wirkende Anpresskraft ohne Federweg und/oder über ein inkompressibles Element auf die Trägereinrichtung übertragen. Dagegen führt eine Scherkraft, die parallel zur Bedienfläche wirkt, zunächst zu einer Auslenkung des Touchpads bezüglich der Trägereinrichtung.

Durch die Erfindung ergibt sich der Vorteil, dass an dem Touchpad die Anpresskraft des Benutzers immer noch über die starre Anbindung auf die Trägereinrichtung übertragen werden kann und von dort auf die Sensoreinrichtung. Dagegen wird eine parallel zur Bedienfläche wirkende Kraft in eine Auslenkung des Touchpads bezüglich der Trägereinrichtung übersetzt. Das Touchpad kann also parallel zur Bedienfläche beispielsweise hin- und herschwingen. Hierdurch kann in vorteilhafter Weise ein parallel zur Bedienfläche wirkender Anteil einer Kraft zunächst in eine Ausweichbewegung des Touchpads umgewandelt werden, sodass die Berührscheibe des Touchpads hierdurch diesem Anteil der Kraft z.B. elastisch ausweichen kann und so vor Bruch geschützt werden kann. Das Touchpad kann auch als Bildschirm ausgestaltet sein, d.h. als Berührbildschirm oder Touchscreen.

Durch das zumindest eine Schwenkelement ist bevorzugt eine gekrümmte, insbesondere kreisförmige, Bewegungsbahn des Touchpads vorgegeben. Hierdurch kann in vorteilhafter Weise auch einem senkrecht zur Bedienfläche wirkenden Anteile einer Anpresskraft ausgewichen werden, wenn sich z.B. der Benutzer mit dem Handballen auf dem Touchpad aufstützt oder auflehnt. Die zur Bedienfläche parallele Beweglichkeit ergibt sich also in der Ruheposition des Touchpads, wenn es mit keiner Anpresskraft beaufschlagt ist.

Bei der Erfindung ist das Touchpad mittels des zumindest einen Schwenkelements bezüglich der Trägereinrichtung monostabil auslenkbar gelagert. Mit anderen Worten wird das Touchpad mittels des zumindest einen Schwenkelements in einer vorbestimmten Ruheposition gehalten, falls keine Kraft auf die Bedienfläche wirkt. Hierdurch kann das Touchpad in vorteilhafter Weise Schlägen und/oder Impulsen elastisch ausweichen.

In einer Weiterbildung der Erfindung weist das zumindest eine Schwenkelement eine Blattfeder und/oder eine Schenkelfeder auf. Entlang der Erstreckungsebene der Blattfeder beziehungsweise der Erstreckungsrichtung eines Schenkels einer Schenkelfeder lässt sich die Anpresskraft starr von dem Touchpad auf die Trägereinrichtung übertragen. Dagegen ergibt sich eine elastische Verformung der Blattfeder und der Schenkelfeder, falls die Kraft quer zur Erstreckungsebene der Blattfeder beziehungsweise der Erstreckungsrichtung des Schenkels der Schenkelfeder wirkt. Hierdurch kann die beschriebene Lagerung des Touchpads bezüglich der Trägereinrichtung in vorteilhafter Weise mit einfachen mechanischen Mitteln bereitgestellt werden.

In einer Weiterbildung der Erfindung weist die Bedienvorrichtung eine Aktoreinrichtung auf, beispielsweise einen elektro-mechanischen Rüttler oder einen Elektromotor mit einer Unwucht oder ein Piezoelement. Diese Aktoreinrichtung ist dazu ausgelegt, zum Erzeugen einer haptischen Rückmeldung das Touchpad parallel zu der Bedienfläche bezüglich der Trägereinrichtung auszulenken. Mit anderen Worten wird die beschriebene Beweglichkeit des Touchpads nicht nur zum Schutz der Berührscheibe, sondern auch zum Erzeugen einer haptischen Rückmeldung genutzt.

In einer Weiterbildung der Erfindung weist die Trägereinrichtung ein Schwenkhebelelement auf. Dieses Schwenkhebelelement ist durch eine Drehgelenkeinrichtung drehbar bezüglich der Sensoreinrichtung gelagert. An diesem Schwenkelement ist das Touchpad mittels des zumindest einen Schwenkelements befestigt. Beispielsweise kann also das Touchpad mittels einer oder mehrerer Blattfedern an dem Schwenkhebelelement angeordnet sein. Als Schwenkelement kann beispielsweise ein Klappbügel oder eine Klappe bereitgestellt sein, wobei das Schwenkhebelelement an der Sensoreinrichtung anliegt.

Das Touchpad weist bevorzugt entlang des Schwenkhebelelements einen Abstand größer als Null zu der Drehgelenkeinrichtung auf. Mit anderen Worten ist eine radialer Abstand des Touchpads zur Drehachse der Drehgelenkeinrichtung größer als Null, insbesondere größer als 1 Zentimeter, bevorzugt größer als 2 Zentimeter. Hierdurch kann eine Anpresskraft auf der gesamten Bedienfläche des Touchpads zuverlässig mittels der Sensoreinrichtung erfasst werden.

In Bezug auf die Berührscheibe sieht eine Weiterbildung vor, dass diese eine Glasscheibe ist. Hierdurch ergibt sich der Vorteil, dass die Berührfläche einfach zu reinigen und auch resistent gegen Körpersäure ist.

Eine Weiterbildung der Erfindung sieht vor, dass in der beschriebenen Weise bei dem Touchpad eine Sensormatrix mit einer Vielzahl von an unterschiedlichen Orten angeordneten Sensoren zum jeweiligen Erfassen eines Bedienobjekts, beispielsweise eines Fingers, bei dessen Annäherung und/oder Berührung der Bedienfläche erfasst wird. Diese Sensormatrix ist auf einer Leiterplatte angeordnet. Die Leiterplatte und die Berührscheibe sind zu einer Schichtanordnung verbunden, bei welcher die Leiterplatte zumindest in einem überwiegenden Bereich der Bedienfläche, bevorzugt im gesamten Bereich der Bedienfläche, die Berührscheibe bei einer Beaufschlagung der Bedienfläche mit der Anpresskraft gegen eine druckkraftbedingte Verformung stützt. Mit anderen Worten befindet sich zwischen der Leiterplatte und der Berührscheibe kein Hohlraum oder Luftspalt. Dies kann beispielsweise durch Verkleben der Leiterplatte mit der Berührscheibe erreicht werden. Hierdurch ergibt sich der Vorteil, dass die Berührscheibe gegen ein Durchbiegen senkrecht zur Bedienfläche durch die Leiterplatte gestützt wird.

Um diesen Effekt zu verstärken, sieht eine Weiterbildung vor, dass die Schichtanordnung eine zusätzliche Trägerplatte aufweist, die mit einer von der Berührscheibe abgewandten Seite der Leiterplatte koplanar verbunden ist. Durch eine Beaufschlagung der Bedienfläche mit der Anpresskraft wird also die Leiterplatte durch die Trägerplatte gestützt. Die sich hierdurch ergebende, besonders steife Schichtanordnung weist den Vorteil auf, dass sie mit wenigen Schwenkelementen, also beispielsweise mit wenigen Blattfedern, insbesondere mit einer, zwei, drei oder vier Blattfedern das Touchpad an der Trägereinrichtung befestigt werden kann, ohne dass hierdurch Bruchgefahr der Berührscheibe besteht, wenn Anpresskraft senkrecht zur Bedienfläche wirkt. Die Biegesteifigkeit der Schichtanordnung ist groß genug.

Schließlich ist in einer Weiterbildung der Erfindung vorgesehen, dass diese eine Steuereinrichtung aufweist, die dazu ausgelegt ist, ein Steuersignal zum Steuern eines Geräts des Kraftfahrzeugs in Abhängigkeit von dem Berührsignal des Touchpads und dem Drucksignal der Sensoreinrichtung zu erzeugen. Die Steuereinrichtung kann beispielsweise durch ein Steuergerät und/oder einen Mikrocontroller bereitgestellt sein.

Zu der Erfindung gehört auch ein Kraftfahrzeug. Das erfindungsgemäße Kraftfahrzeug weist zumindest eine Bedienvorrichtung auf, die eine Ausführungsform der erfindungsgemäßen Bedienvorrichtung darstellt. Das erfindungsgemäße Kraftfahrzeug ist bevorzugt als Kraftwagen, insbesondere als Personenkraftwagen, ausgestaltet.

Im Folgenden ist ein Ausführungsbeispiel der Erfindung beschrieben. Hierzu zeigt:
- Fig. 1: eine schematische Darstellung eines Längsschnitts durch eine Ausführungsform der erfindungsgemäßen Bedienvorrichtung,
- Fig. 2: eine schematische Darstellung eines Schwenkelements mit einer Blattfeder, und
- Fig. 3: eine schematische Darstellung eines Schwenkelements mit einer Schenkelfeder.

Bei dem im Folgenden erläuterten Ausführungsbeispiel handelt es sich um eine bevorzugte Ausführungsform der Erfindung. Bei dem Ausführungsbeispiel stellen aber die beschriebenen Komponenten der Ausführungsform jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren ist die beschriebene Ausführungsform auch durch weitere der bereits beschriebenen Merkmale der Erfindung ergänzbar.

In den Figuren sind funktionsgleiche Elemente jeweils mit denselben Bezugszeichen versehen.

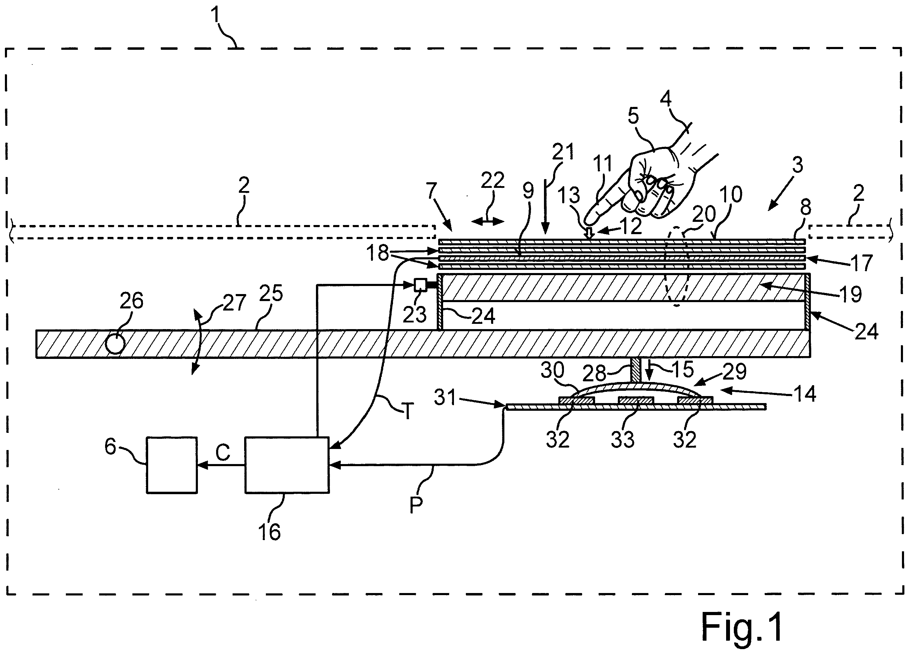

Fig. 1 zeigt von einem Kraftfahrzeug 1 ein Verkleidungsteil 2. Bei dem Kraftfahrzeug 1 kann es sich beispielsweise um einen Kraftwagen, insbesondere einen Personenkraftwagen, handeln. Bei dem Verkleidungsteil 2 kann es sich beispielsweise um eine Mittelkonsole oder ein Armaturenbrett handeln. In dem Verkleidungsteil 2 kann eine Bedienvorrichtung 3 angeordnet sein. Mittels der Bedienvorrichtung 3 kann ein Benutzer 4, von dem in Fig. 1 lediglich eine Hand 5 dargestellt ist, beispielsweise ein Gerät 6 des Kraftfahrzeugs oder mehrere Geräte des Kraftfahrzeugs 1, bedienen. Beispielsweise kann es sich bei dem Gerät 6 um ein Information-/Unterhaltungssystem (Infotainmentsystem) und/oder ein Navigationsgerät und/oder ein Telefon und/oder ein Medienwiedergabegerät, beispielsweise ein Radio, handeln. Zum Bedienen des Geräts 6 kann die Bedienvorrichtung 3 ein Touchpad 7 aufweisen. Das Touchpad 7 kann durch eine Berührscheibe 8 und eine (nicht näher dargestellte) Sensormatrix 9 in an sich bekannter Weise gebildet sein. Durch die Berührscheibe 8 kann eine Berührfläche 10 bereitgestellt sein, an welcher der Benutzer 4 mit einem Finger 11 der Hand 5 an einem Berührort 12 eine Berührkraft oder Anpresskraft 13 ausüben oder übertragen kann. In Abhängigkeit von dem Berührort 12, das heißt der Berührstelle, welcher sich der Finger 11 nähert oder welche der Finger 11 berührt, kann die Sensormatrix 9 in an sich bekannter Weise, beispielsweise durch kapazitive Erfassung, ein Berührsignal T erzeugen. Die Anpresskraft 13 kann bei der Bedienvorrichtung 3 mittels einer Sensoreinrichtung 14 erfasst werden, welche die Anpresskraft 3 als Druckkraft 15 erfassen kann. In Abhängigkeit von der Druckkraft 15 kann durch die Sensoreinrichtung 14 ein Drucksignal P erzeugt werden.

Die Bedienvorrichtung 3 kann eine Steuereinrichtung 16 aufweisen, die beispielsweise durch einen Mikrocontroller oder eine andere integrierte Schaltung bereitgestellt sein kann. Die Steuereinrichtung 16 kann dazu ausgelegt sein, in Abhängigkeit von dem Berührsignal T und dem Drucksignal P ein Steuersignal C zu erzeugen, durch welches das Gerät 6 gesteuert wird. Es kann auch vorgesehen sein, dass das Steuersignal C ausschließlich in Abhängigkeit von dem Berührsignal T erzeugt wird. Dies kann beispielsweise für einen Zeichenbereich auf der Bedienfläche 10 für eine Handschrifterkennung oder eine Gestenerkennung vorgesehen sein.

Die Berührscheibe 8 kann beispielsweise aus Glas gebildet sein. Insbesondere kann Kalk-Natron-Glas vorgesehen sein, das in der Herstellung besonders günstig ist. Es kann beispielsweise ein sogenanntes Floatglas verwendet werden, das sich in einem Massenherstellungsprozess besonders preisgünstig herstellen lässt.

Die Berührscheibe 8 ist bei der Bedienvorrichtung 3 in besonderer Weise gegen eine Kraftbeaufschlagung geschützt, die beispielsweise durch einen auf die Bedienfläche 10 fallenden Fahrzeugschlüssel oder durch eine sich auf die Bedienfläche 10 stützende Hand verursacht sein kann. Des Weiteren ergibt sich in vorteilhafter Weise eine Dämpfung von Schlägen oder Impulsen.

Um ein Biegemoment der Berührscheibe 8 zu vergrößern, kann vorgesehen sein, dass die Sensormatrix 9 auf einer Schaltungsplatine oder Leiterplatte 17 angeordnet ist, die über eine Klebeschicht 18 an der Berührscheibe 8 angeordnet ist. Die Berührscheibe und die Leiterplatte 17 sind dabei koplanar angeordnet. Des Weiteren kann zur zusätzlichen Stützung eine Trägerscheibe 19 vorgesehen sein, die über eine weitere Klebeschicht 18 mit der Leiterplatte 17 verbunden sein kann. Auch die Leiterplatte 17 und die Trägerplatte 19 sind dann koplanar angeordnet. Hierdurch kann ein Biegemoment der sich ergebenden Sandwich-Anordnung oder Schichtanordnung 20 in senkrechter Richtung 21 bezüglich der Berührfläche 10 ausreichend groß eingestellt werden, sodass bis zu einer vorbestimmbaren Höchstkraft die Scheibe 8 gegen Bruch bei Beaufschlagung mit einer Kraft in senkrechter Richtung 21 geschützt ist. Durch Wahl einer entsprechenden Klebeschicht 18, beispielsweise mittels eines elastischen Klebers, kann in senkrechter Richtung 21 auch ein Impuls oder Stoß in vorteilhafter Weise gedämpft werden.

Die Berührscheibe 8, oder allgemein das Touchpad 7, kann in seiner Ruheposition in einer Bewegungsebene in paralleler Richtung 22 zur Berührfläche 10 bewegbar gelagert sein. Hierdurch kann in vorteilhafter Weise ein Aktor 23 bereitgestellt werden, beispielsweise eine Elektromotor oder ein Piezo-Aktor, mittels welchem das Touchpad 7 in der parallelen Richtung 22 beispielsweise periodisch bewegt oder geschüttelt werden kann, um hierdurch am Finger 11 eine haptische Rückmeldung zu erzeugen. Der Aktor 23 kann beispielsweise durch die Steuereinrichtung 16 bei Erzeugung eines Steuersignals C aktiviert werden. Hierdurch weiß der Benutzer 4, dass seine Eingabe erfolgreich erkannt worden ist.

Um trotz der beweglichen Lagerung die Anpresskraft 13 auf die Sensoreinrichtung 14 als Druckkraft 15 übertragen zu können, kann das Touchpad 7, insbesondere die Schichtanordnung 20 insgesamt, mittels Schwenkelementen 24 an einem Schwenkarmelement 25 befestigt sein. Das Schwenkarmelement 25 wiederum kann mittels einer Drehgelenkeinrichtung 26, beispielsweise einem oder mehreren Drehgelenken, entlang einer Drehrichtungsebene 27 drehbar bezüglich der Sensoreinrichtung 14 gelagert sein. Das Schwenkarmelement 25 kann beispielsweise über ein Anlageelement 28, beispielsweise einen Stutzen oder einen Stab, an einem Sensor 29 der Sensoreinrichtung 14 anliegen. Mittels des Sensors 29 kann das Drucksignal P erzeugt werden. Der Sensor 29 kann hierzu beispielsweise eine Tellerfeder 30 aufweisen, welche an einer Leiterplatte 31 befestigt sein kann. Beispielsweise kann die Tellerfeder 30 an Leiterbahnen 32 angelötet sein. Eine weitere Leiterbahn 33 kann eine Gegenelektrode zu der Tellerfeder 30 bilden, sodass durch die Tellerfeder 30 und die Leiterbahn 33 ein kapazitiver Sensor zum Erzeugen des Drucksignals P gebildet sein kann. Bei Beaufschlagen der Tellerfeder 30 mit der Druckkraft 15 kann sich die Tellerfeder 30 verformen und hierdurch sich ein Abstand der Tellerfeder 30 zur Gegenelektrode 33 verändern, was in an sich bekannter Weise zur Erzeugung des Drucksignals P genutzt werden kann.

Um auch beispielsweise ein Antippen der Berührfläche 10 mittels des Fingers 11 übertragen zu können, darf der durch das Tippen auf die Berührfläche 10 übertragene Impuls nicht zu stark gedämpft werden. Hierzu muss die Anpresskraft 13 über eine möglichst starre Verbindung auf den Sensor 29 übertragen werden.

Hierzu können bei der Bedienvorrichtung 3 die Schwenkelemente 24 wie folgt ausgestaltet sein.

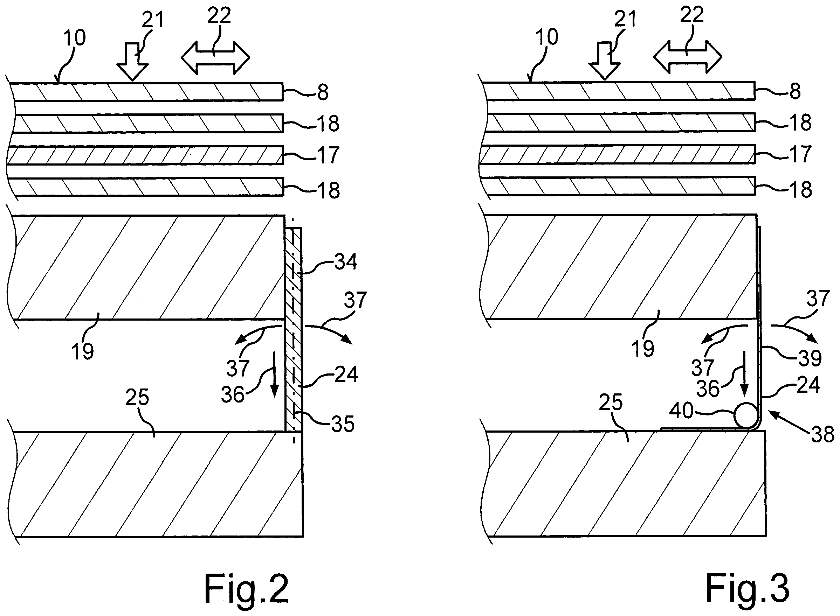

In Fig. 2 ist veranschaulicht, wie ein Schwenkelement 24 durch eine Blattfeder 34 bereitgestellt sein kann. Eine Erstreckungsebene 35 der Blattfeder 34 kann parallel zur senkrechten Richtung 21 bezüglich der Berührfläche 10 ausgerichtet sein. Hierdurch kann die Anpresskraft 13 entlang der senkrechten Richtung 21 als axiale Kraft 36 durch die Blattfeder 34 übertragen werden. Dagegen kann entlang der parallelen Auslenkung 22 parallel zur Berührfläche 10 eine derart wirkende Scherkraft parallel zur Berührfläche 10 eine Ausweichbewegung 37 der Blattfeder 34 hervorrufen. Hierdurch wird die bewegliche Lagerung des Touchpads 7 in parallelen Richtungen 22 bezüglich des Schwenkarmelements 25 erreicht.

In Fig. 3 ist gezeigt, wie ein Schwenkarmelement 24 mittels einer Schenkelfeder 38 realisiert werden kann. Die Anpresskraft 13 entlang der senkrechten Richtung 21 kann als achsparallele Kraft 36 entlang eines Schenkels 39 der Schenkelfeder 38 und über beispielsweise eine Spiralfeder 40 auf das Schwenkarmelement 25 übertragen werden. Durch die Verschwenkbarkeit des Schenkels 39 um eine Achse der Spiralfeder 40 ergibt sich die bewegbare Lagerung für die Ausweichbewegungen 37.

Somit ist bei der Bedienvorrichtung 3 die Möglichkeit bereitgestellt, ein Glas-Touchpad mit dessen Unterbau (Mechanik) darzustellen und hierbei die Bruchfestigkeit zu erhöhen. Diese Bruchfestigkeit ist speziell bei einer Echt-Glas-Oberfläche vorteilhaft.

Die Echt-Glas-Oberfläche (Touchpad) wird auf der Leiterplatte 17 befestigt, insbesondere geklebt. Darunter wird der Träger 19 befestigt, insbesondere ebenfalls geklebt. Dieser Sandwich-Aufbau wird über Blattfedern mit einem Schwenkhebel verbunden. Dieser Hebel ist drehend gelagert und liegt auf den Auswerte-Sensoren für die Druckkraft, also den Kraftsensoren, auf. Durch diesen Aufbau/Unterbau wird die Echt-Glas-Oberfläche entsprechend gelagert/gedämpft, welches die Bruchfestigkeit erhöht.

Insgesamt zeigt das Beispiel, wie durch die Erfindung ein Glas-Touchpad mit mechanischem Unterbau zur Erhöhung der Bruchfestigkeit bereitgestellt werden kann.

## Patentansprüche

1. Bedienvorrichtung (3) für ein Kraftfahrzeug (1), aufweisend:
- ein Touchpad (7) zum Erzeugen eines von einem Berührort (12) auf einer Bedienfläche (10) einer Berührscheibe (8) des Touchpads (7) abhängigen Berührsignals (T),
- eine Sensoreinrichtung (14) mit zumindest einem Sensor (29) zum Erzeugen eines von einer auf den Sensor (29) wirkenden Druckkraft (15) abhängigen Drucksignals (P),
- eine Trägereinrichtung (25), durch welche das Touchpad (7) bezüglich der Sensoreinrichtung (14) derart bewegbar gelagert ist, dass eine von einem Benutzer (4) auf die Bedienfläche (10) ausgeübte Anpresskraft (13) als die Druckkraft (15) auf die Sensoreinrichtung (14) wirkt, wobei
das Touchpad (7) an der Trägereinrichtung (25) mittels zumindest eines Schwenkelements (24) befestigt ist, durch welches das Touchpad (7) zum einen parallel (22) zu der Bedienfläche (10) bezüglich der Trägereinrichtung (25) auslenkbar (37) und zum anderen senkrecht (21) zu der Bedienfläche (10) starr an der Trägereinrichtung (25) gelagert ist, **dadurch gekennzeichnet, dass**
das Touchpad (7) mittels des zumindest einen Schwenkelements (24) bezüglich der Trägereinrichtung (25) monostabil auslenkbar gelagert ist.

2. Bedienvorrichtung (3) nach Anspruch 1, wobei das zumindest eine Schwenkelement (24) eine Blattfeder (34) und/oder eine Schenkelfeder (39) aufweist.

3. Bedienvorrichtung (3) nach einem der vorhergehenden Ansprüche, wobei die Bedienvorrichtung (3) eine Aktoreinrichtung (23) aufweist und die Aktoreinrichtung (23) dazu ausgelegt ist, zum Erzeugen einer haptischen Rückmeldung das Touchpad (7) parallel (22) zu der Bedienfläche (10) bezüglich der Trägereinrichtung (25) auszulenken.

4. Bedienvorrichtung (3) nach einem der vorhergehenden Ansprüche, wobei die Trägereinrichtung (25) ein Schwenkhebelelement aufweist, welches durch ein Drehgelenkeinrichtung (26) drehbar (27) bezüglich der Sensoreinrichtung (14) gelagert ist und an welchem das Touchpad (7) mittels des zumindest einen Schwenkelements (24) befestigt ist.

5. Bedienvorrichtung (3) nach einem der vorhergehenden Ansprüche, wobei die Berührscheibe (8) eine Glasscheibe ist.

6. Bedienvorrichtung (3) nach einem der vorhergehenden Ansprüche, wobei eine Sensormatrix (9) mit einer Vielzahl von an unterschiedlichen Orten angeordneten Sensoren zum jeweiligen Erfassen eines Bedienobjekts (11) bei dessen Annäherung und/oder Berührung der Bedienfläche (10), wobei die Sensormatrix (9) auf einer Leiterplatte (17) angeordnet ist und die Leiterplatte (17) und die Berührscheibe (8) zu einer Schichtanordnung (20) verbunden sind, bei welcher die Leiterplatte (17) zumindest in einen überwiegenden Bereich der Bedienfläche (10) die Berührscheibe (8) bei einer Beaufschlagung der Bedienfläche (10) mit der Anpresskraft (13) gegen eine druckkraftbedingte Verformung stützt.

7. Bedienvorrichtung (3) nach Anspruch 6, wobei die Schichtanordnung (20) eine zusätzliche Trägerplatte (19) aufweist, die mit einer von der Berührscheibe (8) abgewandten Seite der Leiterplatte (17) koplanar verbunden ist und bei der Beaufschlagung der Bedienfläche (10) mit der Anpresskraft (13) die Leiterplatte (17) stützt.

8. Bedienvorrichtung (3) nach einem der vorhergehenden Ansprüche, wobei eine Steuereinrichtung (16) zum Erzeugen eines Steuersignals (C) zum Steuern eines Geräts (6) des Kraftfahrzeugs (1) in Abhängigkeit von dem Berührsignal (T) und dem Drucksignal (P) bereitgestellt ist.

9. Kraftfahrzeug (1) mit zumindest einer Bedienvorrichtung (3) jeweils nach einem der vorhergehenden Ansprüche.

## Claims

1. Operating device (3) for a motor vehicle (1) having
- a touchpad (7) for producing a contact signal (T) which is dependent on a contact location (12) on an operating face (10) of a contact plate (8) of the touchpad (7),
- a sensor device (14) having at least one sensor (29) for producing a pressure signal (P) which is dependent on a pressure force (15) which acts on the sensor (29),
- a carrier device (25) by means of which the touchpad (7) is movably supported with respect to the sensor device (14) in such a manner that a pressing force (13) which is applied by a user (4) to the operating face (10) acts as the pressing force (15) on the sensor device (14), wherein
the touchpad (7) is secured to the carrier device (25) by means of at least one pivot element (24) by means of which the touchpad (7), on the one hand, can be redirected (37) parallel (22) with the operating face (10) with respect to the carrier device (25) and, on the other hand, is rigidly supported on the carrier device (25) perpendicularly (21) to the operating face (10),
**characterised in that**
the touchpad (7) is supported so as to be able to be redirected in a monostable manner by means of the at least one pivot element (24) with respect to the carrier device (25).

2. Operating device (3) according to claim 1, wherein the at least one pivot element (24) has a leaf spring (34) and/or a leg spring (39).

3. Operating device (3) according to any one of the preceding claims, wherein the operating device (3) has an actuator device (23) and the actuator device (23) is configured in order to produce a haptic response to redirect the touchpad (7) parallel (22) with the operating face (10) with respect to the carrier device (25).

4. Operating device (3) according to any one of the preceding claims, wherein the carrier device (25) has a pivot lever element which is rotatably supported by means of a rotary (27) articulation device (26) with respect to the sensor device (14) and on which the touchpad (7) is secured by means of the at least one pivot element (24).

5. Operating device (3) according to any one of the preceding claims, wherein the contact plate (8) is a glass plate.

6. Operating device (3) according to any one of the preceding claims, wherein a sensor matrix (9) having a large number of sensors which are arranged at different locations for detecting in each case an operating object (11) when it approaches and/or contacts the operating face (10), wherein the sensor matrix (9) is arranged on a printed circuit board (17) and the printed circuit board (17) and the contact plate (8) are connected to form a layer arrangement (20), during which the printed circuit board (17) at least in a predominant region of the operating face (10) supports the contact plate (8) when the operating face (10) is acted on with the pressing force (13) counter to a pressure-force-related deformation.

7. Operating device (3) according to claim 6, wherein the layer arrangement (20) has an additional carrier plate (19), which is connected in a coplanar manner to a side of the printed circuit board (17) facing away from the contact plate (8) and supports the printed circuit board (17) when the operating face (10) is acted on with the pressing force (13).

8. Operating device (3) according to any one of the preceding claims, wherein a control device (16) for producing a control signal (C) for controlling a device (6) of the motor vehicle (1) in accordance with the contact signal (T) and the pressure signal (P) is provided.

9. Motor vehicle (1) having at least one operating device (3) in each case according to any one of the preceding claims.

## Revendications

1. Dispositif de commande (3) pour un véhicule automobile (1), présentant :
- une tablette tactile (7) pour la génération d'un signal d'effleurement (T) dépendant d'un lieu d'effleurement (12) sur une surface de commande (10) d'une vitre d'effleurement (8) de la tablette tactile (7),
- un dispositif capteur (14) avec au moins un capteur (29) pour la génération d'un signal de pression (P) dépendant d'une force de pression (15) agissant sur le capteur (29),
- un dispositif de support (25), par lequel la tablette tactile (7) est logée mobile par rapport au dispositif capteur (14) de telle sorte qu'une force d'application (13) exercée par un utilisateur (4) sur la surface de commande (10) agit en tant que force de pression (15) sur le dispositif capteur (14),
dans lequel
la tablette tactile (7) est fixée sur le dispositif de support (25) au moyen d'au moins un élément pivotant (24), par lequel la tablette tactile (7) est logée d'une part de manière à pouvoir être déviée (37) parallèlement (22) à la surface de commande (10) par rapport au dispositif de support (25) et d'autre part de manière rigide perpendiculairement (21) à la surface de commande (10) au niveau du dispositif de support (25),
**caractérisé en ce que**
la tablette tactile (7) est logée de manière à pouvoir être déviée de façon monostable par rapport au dispositif de support (25) au moyen de l'au moins un élément pivotant (24).

2. Dispositif de commande (3) selon la revendication 1, dans lequel l'au moins un élément pivotant (24) présente un ressort à lame (34) et/ou un ressort à branches (39).

3. Dispositif de commande (3) selon l'une quelconque des revendications précédentes, dans lequel le dispositif de commande (3) présente un dispositif actionneur (23) et le dispositif actionneur (23) est conçu pour dévier la tablette tactile (7) parallèlement (22) à la surface de commande (10) par rapport au dispositif de support (25) pour la génération d'un rétrosignal haptique.

4. Dispositif de commande (3) selon l'une quelconque des revendications précédentes, dans lequel le dispositif de support (25) présente un élément de levier pivotant, lequel est logé de manière rotative (27) par rapport au dispositif capteur (14) par un dispositif à articulation tournante (26) et sur lequel la tablette tactile (7) est fixée au moyen de l'au moins un élément pivotant (24).

5. Dispositif de commande (3) selon l'une quelconque des revendications précédentes, dans lequel la vitre d'effleurement (8) est une vitre en verre.

6. Dispositif de commande (3) selon l'une quelconque des revendications précédentes, dans lequel une matrice de capteur (9) avec une pluralité de capteurs agencés à différents endroits pour la détection respective d'un objet de commande (11) lors de son approche et/ou effleurement de la surface de commande (10), dans lequel la matrice de capteur (9) est agencée sur une plaque conductrice (17) et la plaque conductrice (17) et la vitre d'effleurement (8) sont reliées en un agencement en couches (20), dans lequel la plaque conductrice (17) supporte au moins dans une zone prédominante de la surface de commande (10) la vitre d'effleurement (8) lors d'une sollicitation de la surface de commande (10) avec la force d'application (13) contre une déformation due à la force de pression.

7. Dispositif de commande (3) selon la revendication 6, dans lequel l'agencement en couches (20) présente une plaque porteuse supplémentaire (19), qui est reliée de manière coplanaire à un côté de la plaque conductrice (17) opposé à la vitre d'effleurement (8) et supporte la plaque conductrice (17) lors de la sollicitation de la surface de commande (10) avec la force d'application (13).

8. Dispositif de commande (3) selon l'une quelconque des revendications précédentes, dans lequel un dispositif de commande (16) est mis à disposition pour la génération d'un signal de commande (C) pour la commande d'un appareil (6) du véhicule automobile (1) en fonction du signal d'effleurement (T) et du signal de pression (P).

9. Véhicule automobile (1) avec au moins un dispositif de commande (3) respectivement selon l'une quelconque des revendications précédentes.
